# EUROPÄISCHE PATENTSCHRIFT

(11) **EP 1 361 292 B1**
(45) Veröffentlichungstag und Bekanntmachung des Hinweises auf die Patenterteilung: **24.08.2005**
(21) Anmeldenummer: 02010628.2
(22) Anmeldetag: 10.05.2002
(51) Int. Cl.: C23C 14/54, G01B 7/06

(54) **Verfahren zur In-situ-Schichtdickenbestimmung**
Method for measuring coating thickness in-situ
Procédé pour déterminer in-situ l'épaisseur d'une couche

(43) Veröffentlichungstag der Anmeldung: 12.11.2003
(73) Patentinhaber: SIEMENS AKTIENGESELLSCHAFT, 80333 München (DE)
(72) Erfinder: Bast, Ullrich, Dr., 81667 München (DE); Beyer, Roman, 12167 Berlin (DE); Reiche, Ralph, 13465 Berlin (DE)

(56) Entgegenhaltungen:
- DE-A- 3 613 112
- US-A- 4 331 702
- US-A- 4 543 576
- US-A- 4 823 073

## Beschreibung

Die Erfindung betrifft ein Verfahren zur Schichtdickenbestimmung.

Bei Beschichtungsprozessen, wie z.B. Innenalitierungsprozessen (Aluminisierung von Innenflächen), wird die Schichtdicke über eine metallographische Untersuchung ermittelt. Hierzu wird eine Drahtprobe im Beschichtungsprozess an einer repräsentativen Stelle eines zu beschichtenden Bauteils deponiert, nach Beendigung des Beschichtungsprozesses wird die Drahtprobe entnommen und anschließend aufwändig geschnitten und untersucht. Jeder Beschichtungsprozess wird über mitlaufende Arbeitsproben kontrolliert und dokumentiert. Eine zeitnahe Korrektur nicht-qualifiziert ablaufender Beschichtungsprozesse ist mit diesen Mess- und Prüfmethoden nicht möglich. Daher ist diese Form der Qualitätssicherung sehr kostenintensiv.

Das als nächstliegenden Stand der Technik benachtete DE-A-3613112 beschreibt ein Verfahren zur In-situ-Schichtdickenbestimmung, bei dem ein Sensor durch des Beschichtungsverfahren sowie durch das zu behandelnde Bauteil beschichtet wird.

Es ist daher Aufgabe der Erfindung ein Verfahren zur Schichtdickenbestimmung aufzuzeigen, das die oben geschilderten Probleme löst.

Die Aufgabe wird gelöst durch ein Verfahren gemäß Anspruch 1, indem ein Sensor ebenso wie das zu behandelnde Bauteil dem Beschichtungsverfahren ausgesetzt und eine elektrische Eigenschaft dieses Sensors gemessen wird, die sich aufgrund des Beschichtungsverfahren ändert, so dass eine In-situ-Schichtdickenbestimmung während des Beschichtungsverfahrens möglich ist.

Weitere vorteilhafte Ausgestaltungen des Verfahrens sind in den abhängigen Ansprüchen aufgelistet.

Das Verfahren eignet sich insbesondere für Alitierungsprozesse, bei denen Aluminium in ein Bauteil eingebracht wird (Refurbishment).

Als einfache elektrische Messgröße, die für das Beschichtungsergebnis repräsentativ ist, wird dabei vorzugsweise der elektrische Widerstand verwendet.

Der Sensor ist bspw. ein Sinterling, da ein Sinterling das aufgetragene Beschichtungsmaterial in repräsentativer Weise aufnehmen kann (Anlagerungs- und Diffusionsgeschwindigkeit) oder ist bspw. auch porös oder bspw. aus dem Material des zu beschichtenden Bauteils oder aus MCrAlY.

Das Verfahren eignet sich besonders für Beschichtungsprozesse im Inneren eines Bauteils, da diese schlecht zugänglich sind.

Ein Ausführungsbeispiel der Erfindung ist in den Zeichnungen vereinfacht dargestellt.

Es zeigen
Figur 1 ein Bauteil mit einem Sensor, das beschichtet wird, wobei das erfindungsgemäße Verfahren zur Schichtdickenbestimmung verwendet wird, und
Figur 2 eine Messanordnung mit einem Sensor für das erfindungsgemäße Verfahren.

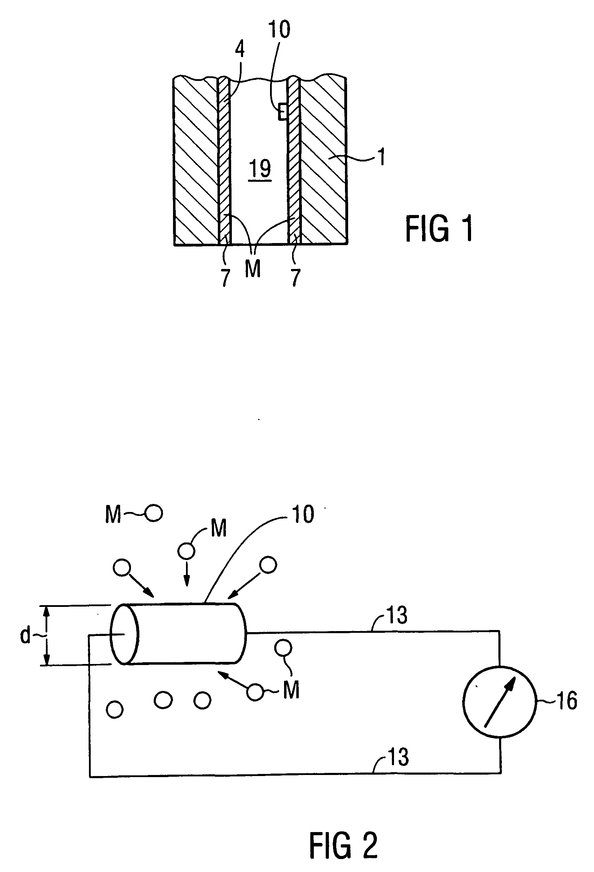

Figur 1 zeigt ein hohles Bauteil 1, das beispielsweise an einer Innenfläche 4 beschichtet werden soll. Das Verfahren kann jedoch auch zur In-situ-Schichtdickenbestimmung von äußeren Flächen verwendet werden.

Auf die Innenfläche 4 wird eine Schicht 7 aus dem Material M mittels bekannter Verfahren, wie z.B. CVD-Verfahren (Chemical Vapour Deposition), elektrochemischer Verfahren oder anderer bekannter Beschichtungsverfahren aufgetragen. Ein Sensor 10 ist im Hohlraum 19 des Bauteils 1 angeordnet und wird somit ebenso wie das zu behandelnde Bauteil 1 beschichtet.
Figur 2 zeigt den Sensor 10 in vergrößerter Darstellung.

Der Sensor 10 besteht aus einem Material, das eine elektrische Eigenschaft wie z.B. elektrischer Widerstand, Impedanz, Kapazität oder ähnliches durch eine beliebige Interaktion mit dem Material M, das die Schicht bildet, verändert. Der Sensor 10 kann beliebige Formen annehmen, also z.B. ein Drahtstück sein oder eine Plättchenform aufweisen.

Der Sensor 10 ist über elektrische Leitungen 13 mit einem elektrischen Messgerät 16 verbunden, das die elektrische Größe misst, die sich durch die Beschichtung des Sensors 10 mit dem Material M verändert. Über in Vorversuchen ermittelte Kalibrierungskurven ist die Abhängigkeit der Schichtdicke von der elektrischen Größe bekannt.

Insbesondere bei Innenalitierungsprozessen, bei dem Aluminium auf eine Innenfläche 4 eines Bauteils 1 aufgebracht wird (M = Al) findet das Verfahren Verwendung. Der Sensor besteht dabei beispielsweise aus dem Material MCrAlY (M = Fe, Co, Ni) und verändert mit dem Aluminium, das bei einem CVD-Prozess aufgetragen wird, in der Weise, dass der gemessene elektrische Kenngröße sich in repräsentativer Weise zum Beschichtungsergebnis verändert.

## Patentansprüche

1. Verfahren zur In-situ-Schichtdickenbestimmung während einer Alitierung eines Bauteils (1),
wobei das Bauteil (1) durch Diffusion
Beschichtungsmaterial aufnimmt,
und bei dem ein Sensor (10) durch die Alitierung so verändert wird,
dass **dadurch** eine elektrische Eigenschaft des Sensors (10) beeinflusst wird,
die mit der Schichtdicke korreliert und die Veränderung der elektrischen Eigenschaft zur Schichtdickenbeschichtung herangezogen wird.

2. Verfahren nach Anspruch 1,
**dadurch gekennzeichnet, dass**
der Sensor (10) aus MCrAlY besteht, wobei M ein Element der Gruppe Eisen, Kobalt oder Nickel ist.

3. Verfahren nach Anspruch 1,
**dadurch gekennzeichnet, dass**
die elektrische Eigenschaft der elektrische Widerstand ist.

4. Verfahren nach Anspruch 1,
**dadurch gekennzeichnet, dass**
der Sensor (10) ein gesintertes Teil ist.

5. Verfahren nach Anspruch 1,
**dadurch gekennzeichnet, dass**
die Alitierung ein CVD-Prozess (Chemical Vapour Deposition) ist.

6. Verfahren nach Anspruch 1,
**dadurch gekennzeichnet, dass**
die Alitierung zur Innenbeschichtung eines Bauteils (1) verwendet wird.

## Claims

1. Method for in situ layer thickness determination while alitizing a component (1), in which the component (1) takes up coating material through diffusion, and in which a sensor (10) is changed by the alitizing in such a way that as a result an electrical property of the sensor (10) which bears a correlation to the layer thickness is influenced, and the change in the electrical property is used to determine the layer thickness.

2. Method according to Claim 1, **characterized in that** the sensor (10) consists of MCrAlY, where M is an element selected from the group consisting of iron, cobalt and nickel.

3. Method according to Claim 1, **characterized in that** the electrical property is the electrical resistance.

4. Method according to Claim 1, **characterized in that** the sensor (10) is a sintered part.

5. Method according to Claim 1, **characterized in that** the alitizing is a CVD (chemical vapour deposition) process.

6. Method according to Claim 1, **characterized in that** the alitizing is used for the internal coating of a component (1).

## Revendications

1. Procédé de détermination in situ de l'épaisseur d'une couche pendant une alumination d'un élément (1),
dans lequel l'élément (1) absorbe de la matière de revêtement par diffusion,
et dans lequel un capteur (10) est modifié par l'alumination,
de manière à influer sur une propriété électrique du capteur (10),
qui est corrélée à l'épaisseur de couche et on tire parti de la modification de la propriété électrique pour la détermination de l'épaisseur de la couche.

2. Procédé suivant la revendication 1,
**caractérisé en ce que** le capteur (10) est en MCrAlY, M étant un élément du groupe fer, cobalt ou nickel.

3. Procédé suivant la revendication 1,
**caractérisé en ce que** la propriété électrique est la résistance électrique.

4. Procédé suivant la revendication 1,
**caractérisé en ce que** le capteur (10) est une pièce frittée.

5. Procédé suivant la revendication 1,
**caractérisé en ce que** l'alumination est une opération CVD (Chemical Vapour Deposition).

6. Procédé suivant la revendication 1,
**caractérisé en ce que** l'alumination est utilisée pour le revêtement intérieur d'un élément (1).
